(19) Europäisches Patentamt
European Patent Office
Office européen des brevets

(11) Veröffentlichungsnummer: 0 009 190
B1

(12) # EUROPÄISCHE PATENTSCHRIFT

(45) Veröffentlichungstag der Patentschrift: 28.04.82

(21) Anmeldenummer: 79103349.1

(22) Anmeldetag: 07.09.79

(51) Int. Cl.³: C 08 L 63/04, H 05 K 3/28, H 05 K 3/34, H 01 B 3/42, H 01 B 3/40, B 23 K 35/22

(54) **In Siebdruck verarbeitbare härtbare Zusammensetzung, ein gehärteter Überzug aus dieser Zusammensetzung und Verfahren zum Löten von Schaltkarten unter Verwendung dieser Zusammensetzung.**

(30) Priorität: 27.09.78 US 946008

(43) Veröffentlichungstag der Anmeldung: 02.04.80 Patentblatt 80/7

(45) Bekanntmachung des Hinweises auf die Patenterteilung: 28.04.82 Patentblatt 82/17

(84) Benannte Vertragsstaaten: DE FR GB

(56) Entgegenhaltungen:
FR - A - 1 484 525
FR - A - 2 128 320
US - A - 3 686 045
US - A - 3 741 858
US - A - 4 129 678

IBM TECHNICAL DISCLOSURE BULLETIN, Band 7, Nr. 9 Februar 1965, Seite 735, New York, U.S.A. R. H. TROXELL: "Screenable Epoxy-Anhydride System for Printed Circuit Boards"

(73) Patentinhaber: International Business Machines Corporation
Armonk, N.Y. 10504 (US)

(72) Erfinder: Kenney, Eugene John
Box 329A R. D. 2
Apalachin, NY 13732 (US)
Erfinder: Lazzarini, Donald Joseph
909 Murray Hill Rd.
Binghamton, NY 13903 (US)
Erfinder: Winters, Robert John
3616 Lyndale Dr.
Endwell, NY 13760 (US)

(74) Vertreter: Kreidler, Eva-Maria, Dr. rer. nat.
Schönaicher Strasse 220
D-7030 Böblingen (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 009 190 B1

# In Siebedruck verarbeitbare härtbare Zusammensetzung, ein gehärteter Überzug aus dieser Zusammensetzung und Verfahren zum Löten von Schaltkarten unter Verwendung dieser Zusammensetzung

Die Erfindung betrifft eine im Siebdruck verarbeitbare, härtbare Zusammensetzung, einen gehärteten Überzug aus derselben und ein Verfahren zum Löten von Schaltkarten unter Verwendung einer Lötmaske aus der erfindungsgemäßen Zusammensetzung.

Bei der Herstellung von hochwertigen gedruckten Schaltkarten ist es erforderlich, die Unterlage in bestimmten Bereichen mit einem zähen, widerstandsfähigen Überzug zu versehen, der als Lötmaske dient. Bei hochwertigen gedruckten Schaltkarten wird ein geschmolzenes Lot verwendet, um eine gute Verbindung zwischen den Komponenten und den Schaltkreisen zu gewährleisten.

Die Überzugszusammensetzungen, die zu diesem Zweck verwendet werden, müssen eine Anzahl wichtiger Eigenschaften aufweisen. Im einzelnen müssen die Überzüge eine hervorragende Haftung auf einer Vielzahl von metallischen und nichtmetallischen Unterlagen aufweisen und harten Umweltbedingungen wie hoher Luftfeuchtigkeit und erhöhten Temperaturen widerstehen. Die Zusammensetzungen müssen auch undurchlässig für eine Vielzahl von Lösungsmitteln, widerstandsfähig gegenüber einer großen Zahl von verschiedenen Chemikalien und insbesondere widerstandsfähig gegenüber den üblicherweise verwendeten Flußmittelzusammensetzungen und Loten sein.

Darüber hinaus müssen die Überzüge, weil sie in Form der Lötmasken als Schutzüberzug auf den Schaltkreisen verbleiben, über einen langen Zeitraum gute elektrisch isolierende Eigenschaften besitzen. Die Zusammensetzungen müssen auch dauerhaft sein und die zuvorgenannten Eigenschaften sogar noch nach langen Zeiten der Einwirkung einer Vielzahl von Chemikalien und schlechter Umweltbedingungen aufweisen. Die Lötmasken verbleiben auf den Schaltkreisen, um diese gegen Oxidation und negative Einflüsse von Gasen, wie Schwefeldioxid, Schwefelwasserstoff und Chlor zu schützen.

Die Zusammensetzungen müssen auch, wenn sie im Siebdruckverfahren bearbeitbar sein sollen, eine gute Maßbeständigkeit des Musters ergeben, welche in hohem Grad von der Fließcharakteristik der Zusammensetzung abhängig ist. Beim Siebdruckverfahren wird ursprünglich eine Überzugszusammensetzung durch die offenen Maschen eines angespannten Materials, beispielsweise eines Drahtsiebs, auf die zu bedruckende Oberfläche gepreßt. Das Sieb ist teilweise durch ein Maskierungsmaterial bedeckt oder abgedichtet, damit das gewünschte Muster auf der zu bedruckenden Unterlage erhalten wird. Als Maskierungsmaterial kann eine Schablone dienen, oder es kann ein getrockneter Lack, Schellack oder Leim verwendet werden. Nachdem das Sieb teilweise mit dem Maskierungsmaterial bedeckt oder abgedichtet ist, wird es, über einen Rahmen gespannt, über der gewünschten Unterlage angeordnet. Die Beschichtungszusammensetzung wird dann auf das Sieb gegossen und durch die offenen Bereiche mittels einer Andruckrolle gepreßt. Anschließend wird der Rahmen entfernt und die beschichtete Unterlage getrocknet. Wenn ein gewünschtes Muster erhalten werden soll, ist es wesentlich, daß die Beschichtungszusammensetzung nicht aus den gewünschten Bereichen, welche durch die offenen Bereiche des Siebs definiert sind, ausfließt oder ausblutet, sondern genau dem Bildmuster auf dem Sieb folgt und dieses reproduziert.

Aufgabe der Erfindung ist eine härtbare Zusammensetzung, die im Siebdruckverfahren verarbeitbar ist und die eingangsgenannten Eigenschaften aufweist, welche ihre Verwendung als Lötmaske und Schutzüberzug gestatten.

Die Aufgabe der Erfindung wird gelöst durch eine Zusammensetzung der eingangs genannten Art, die gekennzeichnet ist durch folgende Bestandteile:

Aus der deutschen Patentschrift 21 09 471 (FR—A 2 128 320) ist ein Verfahren zur Herstellung von Überzügen aus Epoxidharzen, einem Thixotropiermittel, gegebenenfalls einem reaktiven Verdünner und einem Amin-Epoxidharz-Härtesystem bekannt, bei dem man eine Epoxidharzzusammensetzung herstellt, indem man

A. 100 Gewichtsteile einer Mischung aus
- a) 70 bis 95 Gewichtsprozent eines oder mehrerer Epoxidharze mit einem Epoxidwert zwischen 0,50 und 0,64,
- b) gegebenenfalls 5 bis 20 Gewichtsprozent reaktivem Verdünner und
- c) 3 bis 12 Gewichtsprozent hochdispersen Füllstoffen, wobei die Gesamtmischung einen Epoxidwert zwischen 0,46 und 0,50 und eine Viskosität von mindestens 20 Pa.s/25°C besitzt

mit

B. 30 bis 80 Gewichtsteilen einer vorvernetzten Mischung aus
- a) 20 bis 45 Gewichtsprozent eines Gemisches aromatischer Amine,
- b) 30 bis 70 Gewichtsprozent Epoxidharze aus Epichlorhydrin und Diphenylolpropan mit einem mittleren Molekulargewicht von mindestens 20 000,
- c) 1 bis 5 Gewichtsprozent eines Bortrifluorid-Amin-Katalysators, gelöst in 5 bis 25 Gewichtsprozent eines flüchtigen Lösungsmittels

zur Umsetzung bringt, diese Zusammensetzung im Siebdruck auf eine Unterlage aufträgt und nach einer Vakuumbehandlung durch Erhitzen härtet.

Aus der US-Patentschrift 3 686 045 ist eine Überzugszusammensetzung bekannt, die hergestellt wird durch Mischen a) eines Halbveresterungsproduktes eines Epoxidharzes mit dem Anhydrid einer olefinisch ungesättigten Dicarbonsäure, b) eines Vinylmonomeren, c) eines Polycarbonsäureanhydrids, das keine olefinisch ungesättigten Anteile enthält (Nadic methyl anhydrid) mit d) Polymerisationskatalysatoren und Inhibitoren. Nach dem Beschichten größerer Flächen wird diese Zusammensetzung ausgehärtet.

Beide Patentschriften betreffen zwar Überzugszusammensetzungen auf der Bais von Epoxidharzen, jedoch ist die Zusammensetzung in beiden Fällen eine andere als in der vorliegenden Patentanmeldung.

A) 31 bis 55 Gew.% eines epoxidierten Novolaks der allgemeinen Formel

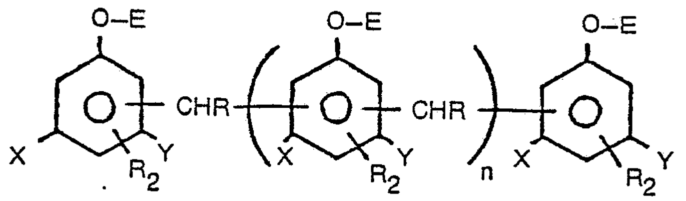

(1)

in der n wenigstens 0,2 ist; R Wasserstoff, Alkyl, Alkylen, Aryl, Aralkyl, Alkaryl, Cycloalkyl oder Furyl bedeutet; X und Y Wasserstoff, Chlor, Alkyl oder Hydroxyl bedeuten; $R_2$ Wasserstoff, Chlor oder eine Kohlenwasserstoffgruppe wie Alkyl, Aryl, Aralkyl, Alkaryl und Cycloalkyl bedeutet; E Wasserstoff oder eine Epoxidalkylgruppe bedeutet und wenigstens zwei Reste E pro Molekül Epoxidalkylgruppen sind, wobei die Epoxidalkylgruppe dargestellt wird durch die allgemeine Formel

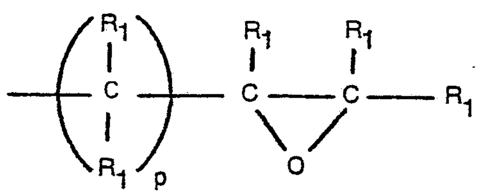

in der p eine Zahl von 1 bis 8 ist und $R_1$ Wasserstoff oder eine Alkylgruppe mit bis zu 7 Kohlenstoffatomen bedeutet und die Anzahl der Kohlenstoffatome in jeder Epoxidalkylgruppe 10 nicht übersteigt;

B) 6 bis 12 Gew.% eines thermoplastischen Polyhydroxyäther-Reaktionsproduktes eines mehrkernigen zweiwertigen Phenols und Epichlorhydrin, das keine 1,2-Epoxidgruppen enthält, der allgemeinen Formel

$$-\!\!\left[O-A-O-CH_2-\underset{\displaystyle OH}{\underset{|}{CH}}-CH_2\right]_m \qquad (2)$$

in der m wenigstens 30 ist und A Rest eines mehrkernigen zweiwertigen Phenols bedeutet;

C) 15 bis 21 Gew.% eines flüssigen Anhydrids einer Carbonsäure;

D) 4 bis 8 Gew.% kolloidalen Siliciumdioxids und

E) flüssiges Verdünnungsmittel in einer Menge, daß die Zusammensetzung eine Viskosität von 14 bis 50 Pa.s, bestimmt mit dem Haake Rotovisco-Viskosimeter bei einer Schubzahl von 249,6/sec. für 1,28 Minuten und 25°C, aufweist

und ein Verhältnis von A zu B zwischen 7:1 und 4:1.

Die Erfindung umfaßt auch einen gehärteten Überzug auf einer Unterlage aus der zuvor genannten Zusammensetzung und ein Verfahren zum Löten von Schaltkarten unter Verwendung der zuvor genannten Zusammensetzung. Vorteilhafte Ausgestaltungen der Erfindung sind in den Unteransprüchen niedergelegt.

Durch die Erfindung wird eine im Siebdruck verarbeitbare Zusammensetzung bereitgestellt, welche die erforderlichen Eigenschaften für ihre Verwendung als Lötmaske und als permanenter Schutzüberzug auf hochwertigen gedruckten Schaltkarten aufweist. Die in siebdruck verarbeitbaren Zusammensetzungen gemäß der Erfindung weisen nicht nur die erforderliche physikalische Charakteristik und die chemische Widerstandsfähigkeit für diesen kritischen Verwendungszweck auf, sie sind auch sehr leicht zu einem Muster verarbeitbar, weil die Zusammensetzungen sehr genau das Bild auf dem Drucksieb reproduzieren. So kann beispielsweise mit den Zusammensetzungen gemäß der Erfindung ein Muster mit einer Maßgenauigkeit innerhalb von 0,1016 mm oder weniger hergestellt werden.

Weiterhin haben die erfindungsgemäßen Zusammensetzungen, verglichen mit anderen, im Siebdruck verarbeitbaren Zusammensetzungen, eine verbesserte Topfzeit. Mit Topfzeit der Zusammensetzung wird deren Stabilität nach dem Mischen unter normalen Umgebungsbedingungen oder bei Zimmertemperatur bezeichnet. Eine ausreichende Topfzeit ist wesentlich, weil einige Zeit erforderlich ist, um die Zusammensetzung nach deren Herstellung auf die gewünschte Unterlage aufzutragen, ohne daß dabei ein Abbau oder ein Härten stattfindet. Es kann auch auf einmal eine größere Menge der Zu sammensetzung hergestellt und vor deren Verwendung aufbewahrt werden, wenn die Topfzeit der Zusammensetzung länger ist. Weiterhin wurde beobachtet, daß in den erfindungsgemäßen Zusammensetzungen während des Härtens der Überzüge eine sehr viel geringere Blasenbildung stattfindet.

In der vorliegenden Erfindung ist wesentlich, daß eine Kombination von epoxidierten Novolakpolymeren und bestimmten thermoplastischen Polyhydroxyäthern oder Phenoxypolymeren in bestimmten relativen Mengen angewendet werden. Es wurde gefunden, daß die Verwendung von Phenoxypolymeren allein, obgleich diese eine gute Dimensionsbeständigkeit ergeben, zu sehr geringer Lösungsmittel- und Hitzebeständigkeit im fertigen Überzug führt. Die Verwendung von epoxidierten Novolakpolymeren allein führt zu einer brüchigen Zusammensetzung, welche die für die vorliegende Erfindung erforderlichen Hafteigenschaften nicht aufweist.

Der epoxidierte Novolak, der in der vorliegenden Erfindung verwendet wird, kann durch die allgemeine Formel dargestellt werden:

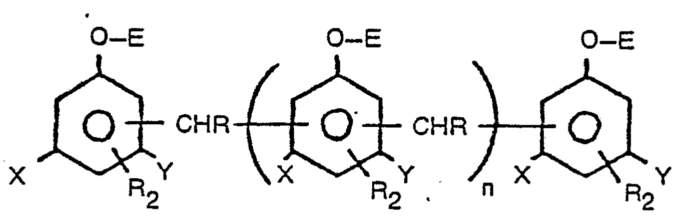

(1)

E, X, Y, R, $R_2$ und n haben in dieser die bereits zuvor angegebenen Bedeutungen. Vorzugsweise sind im wesentlichen alle E-Gruppen Epoxidalkylgruppen. Im allgemeinen enthalten die Reste R, X, Y und $R_2$, wenn diese Kohlenwasserstoffe sind, nicht mehr als etwa 12 Kohlenstoffatome. Die Epoxidnovolake können nach bekannten Verfahren hergestellt werden durch die Reaktion eines thermoplastischen Phenol-Aldehydpolymeren aus einem Phenol der allgémeinen Formel:

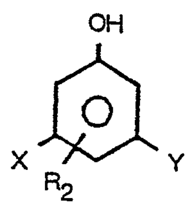

in der X, Y und $R_2$ die bereits zuvor angegebenen bedeutungen haben, mit einem haloepoxidierten Alkan der allgemeinen Formel:

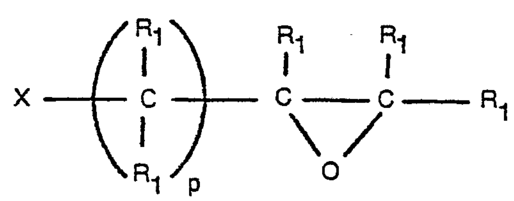

in der X, Y und $R_2$ die bereits zuvor angagebenen Bedeutungen haben, mit einem haloepoxidierten zuvor angegeben besitzen.

Die mit Kohlenwasserstoffen substituierten Phenole, welche zwei verfügbare Stellungen in Ortho- oder Parastellung zur phenolischen Hydroxylgruppe für die Aldehydkondensation aufweisen unter Erhalt von Polymeren, die für die Herstellung epoxidierter Novolake geeignet sind, schließen o- und p-Kresole, o- und p-Äthylphenole, o- und p-Isopropylphenole, o- und p-tert-Butylphenole, o- und p-sec-Butylphenole, o- und p-Amylphenole, o- und p-Octylphenole, o- und p-Nonylphenole, 2,5-Xylenol, 3,4-Xylenol, 2,5-Diäthylphenol, 3,4-Diäthylxylenol, 2,5-Diisopropylphenol, 4-Methylresorcin, 4-Äthylresorcin, 4-Isopropylresorcin, 4-tert.-Butylresorcin, o- und p-Benzylphenole, o- und p-Phenetylphenole, o- und p-Phenylphenole, o- und p-Tolylphenole, o- und p-Xylylphenole, o- und p-Cyclohexylphenole, o- und p-Cyclopentylphenole 4-Phenethylresorcin, 4-Tolylresorcin und 4-Cyclohexylresorcin ein.

Verschiedene chlorsubstituierte Phenole, welche auch zur Herstellung von Phenolaldehydharzen verwendet werden können, die zur Herstellung von Epoxidnovolaken geeignet sind, schließend o- und p-Chlorphenole, 2,5-Dichlorphenol, 2,3-Dichlorphenol, 3,4-Dichlorphenol, 2-Chlor-3-methyl-phenol, 2-Chlor-5-methyl-phenol, 3-Chlor-2-methyl-phenol, 5-Chlor-2-methyl-phenol, 3-Chlor-4-methyl-phenol, 4-Chlor-3-methyl-phenol, 4-Chlor-3-äthyl-phenol, 4-Chlor-3-isopropyl-phenol, 3-Chlor-4-phenyl-phenol, 3,4-Dichlor-phenyl-phenol, 3,5-Dichlor-4-methyl-phenol, 3,5-Dichlor-5-methyl-phenol, 3,5-Dichlor-2-methyl-phenol, 2,3-Dichlor-5-methyl-phenol, 2,5-Dichlor-3-methyl-phenol, 3-Chlor-4,5-dimethyl-phenol, 4-Chlor-3,4-dimethyl-phenol, 2-Chlor-3,5-dimethyl-phenol, 5-Chlor-2,3-dimethyl-phenol, 5-Chlor-3,4-dimethyl-phenol, 2,3,5-Trichlor-phenol, 3,4,5-Trichlor-phenol, 4-Chlor-resorcin, 4,5-Dichlor-resorcin, 4-Chlor-5-methyl-resorcin und 5-Chlor-4-methyl-resorcin ein.

Typische Phenole, welche mehr als zweit Stellen in Ortho- oder Parastellung zur phenolischen Hydroxylgruppe für die Aldehydkondensation aufweisen und welche bei einer kontrollierten Aldehydkondensation auch verwendet werden können, sind: Phenol, m-Kresol, 3,5-Xylenol, m-Äthyl- und m-Isopropylphenole, m,m'-Diäthyl- und Diisopropylphenole, m-Butylphenol, m-Amylphenole, m-Octylphenol, m-Nonylphenol, Resorcin, 5-Methylresorcin, und 5-Äthylresorcin.

Zur Kondensation kann jeder Aldehyd, der mit dem speziell verwendeteten Phenol kondensiert, verwendet werden, einschließlich Formaldehyd, Acetaldehyd, Propionaldehyd, Butyraldehyd, Heptaldehyd, Cyclohexanon, Methylcyclohexanon, Cyclopentanon, Benzaldehyd und am Kern alkylsubstituierte Benzaldehyde wie Toluylaldehyd, Naphthaldehyd, Furfurylaldehyd, Glyoxal, Acrolein, oder Verbindungen, die Aldehydspender sind, wie Paraformaldehyd, Hexamethylentetramin. Die Aldehyde können auch in Form einer Lösung, beispielsweise der im Handel erhältlichen Formalinlösung, verwendet werden.

Obgleich Glycidyläther, welche von Epichlorhydrin abgeleitet werden, bei der Durchführung der Erfindung besonders bevorzugt sind, können auch Epoxidpolymere, welche Epoxid-alkoxy-Gruppen mit einer größeren Anzahl von Kohlenstoffatomen enthalten, verwendet werden. Diese werden hergestellt, indem man Epichlorhydrin durch die entsprechenden typischen Chloride oder Bromide der Monohydroxyepoxidalkane wie 1-Chlor-2,3-epoxybutan, 1-Chlor-3,4-epoxybutan, 2-Chlor-3,4-epoxybutan, 1-Chlor-2-methyl-2,3-epoxypropan, 1-Brom-2,3-epoxypentan, 2-Chlormethyl-1,2-epoxybutan, 1-Brom-4-methyl-3,4-epoxypentan, 1-Brom-4-äthyl-2,3-epoxypentan, 4-Chlor-2-methyl-2,3-epoxypentan, 1-Chlor-2,3-epoxyoctan, 1-Chlor-2-methyl-2,3-epoxyoctan oder 1-Chlor-2,3-epoxydecan ersetzt. Obgleich es möglich ist, Haloepoxidalkane mit einer größeren Zahl von Kohlenstoffatomen als oben angegeben zu verwenden, ist es im allgemeinen nicht von besonderem Vorteil, solche mit einer Gesamtzahl von mehr als 10 Kohlenstoffatomen zu verwenden.

Die bevorzugten epoxidierten Novolake, die erfindungsgemäß verwendet werden, sind gekennzeichnet durch die allgemeine Formel:

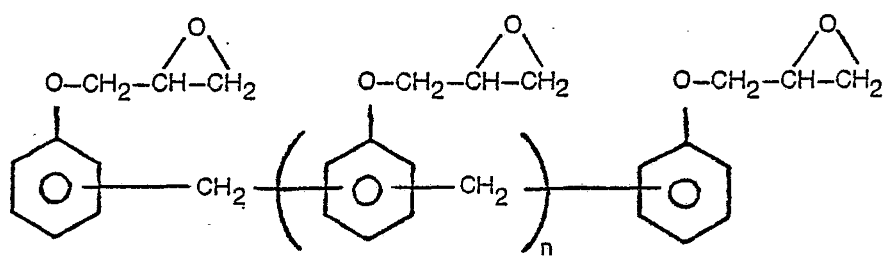

(3)

in der n wenigstens etwa 0,2 ist. Der epoxidierte Novolak kann in Abhängigkeit seines Molekulargewichts flüssig, halbfest oder fest sein. Epoxidpolymere, in denen n 1,5 bis 3,5 ist, sind im Handel erhältlich und im allgemeinen für die Durchführung der vorliegenden Erfindung geeignet. Die bevorzugten Epoxidpolymeren werden durch die oben angegebene Formel dargestellt, in der n wenigstens 1,5 ist. Noch bevorzugter für die Verwendung im Rahmen der vorliegenden Erfindung sind Epoxidpolymere, bei denen n im Bereich von 1,6 bis 2 liegt. Wenn es gewünscht wird, können auch Mischungen epoxidierter Novolakpolymerer der oben angegebenen Formel mit verschiedenen Molekulargewichten verwendet werden.

Diejenigen epoxidierten Novolakpolymeren, welche keine Flüssigkeiten darstellen, werden zur Verwendung in der vorliegenden Erfindung bevorzugt. Flüssige Novolakpolymere werden nicht bevorzugt, weil deren Verwendung im Hinblick auf ein gewisses Ausbluten während des Siebdruckverfahrens zu keiner so guten Musterdefinition führt wie die Verwendung nichtflüssiger epoxidierter Novolakpolymerer. Einige geeignete Novolakpolymere sind in der Veröffentlichung der Dow Chemical Company mit dem Titel "Dow epoxy novolac resins", 1972, Form Nr. 190—20—72 beschrieben.

Die thermoplastischen Polyhydroxyäther, die in der Literatur auch als Phenoxypolymere bezeichnet und in der vorliegenden Erfindung verwendet werden, sind im allgemeinen Reaktionsprodukte im wesentlichen gleicher molarer Mengen eines zweiwertigen Phenols und Epichlorhydrin mit einem Polymerisationsgrad, der einem Molekulargewicht von 20 000 bis 50 000 und vorzugsweise von wenigstens 22 000 entspricht. Um diese Molekulargewichte zu erhalten, muß der Polymerisationsgrad

wenigstens 30 und vorzugsweise wenigstens 70 betragen. Ausgezeichnete Ergebnisse wurden erhalten, wenn Phenoxypolymere mit Molekulargewichten von 25 000 bis 38 000 verwendet wurden. Die Polyhydroxyäther oder Phenoxypolymeren sind im wesentlichen frei von 1,2-Epoxidgruppen.

Die Phenoxypolymeren können durch die wiederkehrende Einheit

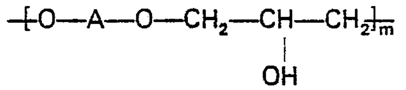 (2)

dargestellt werden, in der A der Rest eines mehrkernigen zweiwertigen Phenols ist. m ist der Polymerisationsgrad und liegt bei wenigstens 30. Bevorzugte Phenoxypolymere sind diejenigen, in denen das zweiwertige Phenol Bisphenol A, 2.2-Bis(p-hydroxyphenyl)propan ist, welches durch die wiederkehrende Einheit

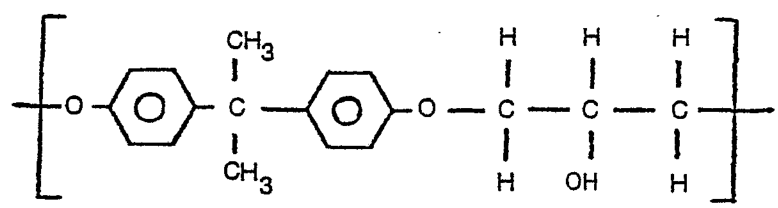 (4)

dargestellt wird. Mit dieser Darstellung der wiederkehrenden Einheiten ist nicht beabsichtigt, zu behaupten, daß die Phenoxypolymeren nur die Konfiguration rein linearer Polymerer haben können. Es kann beispielsweise bis zu einem gewissen Grad auch eine Verzweigung auftreten durch die Reaktion von Epichlorhydrin oder zweiwertigem Phenol oder von beiden mit Hydroxylgruppen der wachsenden Polyhydroxyätherkette. Demzufolge ist die Darstellung der thermoplastischen Phenoxypolymeren durch die wiederkehrende Einheit

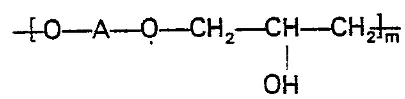

ein brauchbares Mittel zur Angabe der Stöchiometrie und dergleichen, aber sie gibt kein genauses Bild der Struktur, wie man es von einem Monomeren oder einer Verbindung mit niedrigem Molekulargewicht erhalten würde.

Die Phenoxypolymeren, die im Rahmen der vorliegenden Erfindung verwendet werden, sind im wesentlichen frei von 1,2-Epoxidgruppen, wie aus der Anwendung der beiden analytischen "epoxide equivalent" Tests, welche in "Epoxy Resins" von A. Lee und K. Neville, McGraw-Hill, New York 1957 auf den Seiten 21 bis 25 beschrieben sind, hervorgeht. Beispiele einiger geeigneter zweiwertiger Phenole sind zu finden in der US-Patentschrift 3 424 707. Mischungen der Phenoxypolymeren können, wenn es gewünscht wird, auch angewendet werden.

Einige im Handel erhältliche Phenoxypolymere schließen die unter den Warenzeichen Eponol 53, Eponol 55, Epon 1009, Phenoxy PAHJ, Phenoxy PKHC, Phenoxy PKHA und Phenoxy PKHH erhältlichen Polymeren ein.

Um die kritische Kombination von Eigenschaften zu erhalten, welche die Zusammensetzungen der vorliegenden Erfindung für im siebdruck verarbeitbare, härtbare Zusammensetzungen für Lötmasken und permanente Schutzüberzüge hochwertiger gedruckter Schaltkarten brauchbar machen, ist es wesentlich, daß das epoxidierte Novolakpolymere in Mengen von 31 bis 55 Gew.%, vorzugsweise von 45 bis 50 Gew.% und das Phenoxypolymere in Mengen von 6 bis 12 Gew.%, vorzugsweise von 7,5 bis 9,5 Gew.% angewendet wird. Weiterhin ist es wesentlich, daß das Verhältnis des epoxidierten Novolaks zu dem Phenoxypolymeren zwischen 7:1 bis 4:1, vorzugsweise zwischen 7:1 bis 4,5:1 bzw. zwischen 6:1 und 5:1 liegt. Das beste Verhältnis liegt bei etwa 5,5:1. Diese relativen Mengen basieren auf der Gesamtmenge der fünf oben beschriebenen wesentlichen Bestandteile der Zusammensetzung. Weiterhin ist es für die Durchführung der vorliegenden Erfindung wesentlich, daß das verwendete Epoxidpolymere ein epoxidiertes Novolakpolymer und vorzugsweise ein nichtflüssiger epoxidierter Novolak ist. Wenn die erforderlichen relativen Mengen zwischen epoxidiertem Novolak und Phenoxypolymer nicht angewendet werden, oder wenn das Epoxidpolymere kein epoxidierter Novolak ist, dann werden die Eigenschaften für eine im Siebdruck verarbeitbare, härtbare Zusammensetzung mit der verbesserten Charakteristik gemäß der vorliegenden Erfindung nicht erhalten.

Obgleich bereits Mischungen von Phenoxyharzen und bestimmten Epoxidharzen in bestimmten Mengen bekannt sind, ist die bestimmte Zusammensetzung, die durch die vorliegende Erfindung angegeben wird, aus dem Stand der Technik nicht ersichtlich. Im einzelnen werden in den US-Patentschriften 3 741 858 und 3 873 637 adhäsive Zusammensetzungen beschrieben, welche ein

Phenoxyharz und Epoxidharz mit niedrigem Molekulargewicht, das ein Epoxidnovolakharz sein kann, enthalten. In den Zusammensetzungen, die in diesen beiden Patenten beschrieben sind, werden jedoch explizit die relativen Mengen von Epoxidharz und Phenoxyharz, die erfindungsgemäß geforder werden, nicht verwendet. Weiterhin wird durch diese beiden Patente auch nicht die Verwendung der bevorzugten, nichtsflüssigen, epoxidierten Novolakpolymeren gemäß der Erfindung nahegelegt. Darüber hinaus ist aus diesen beiden Patenten kein Hinweis auf die vorliegende Erfindung zu entnehmen, weil diese keine im Siebdruck verarbeitbare Überzugszusammensetzungen betreffen und deshalb auch nicht auf die speziellen Probleme, die im Rahmen der vorliegenden Erfindung angesprochen werden, ausgerichtet sind.

Die US-Patentschrift 3 780 132 betrifft einen Grundierlack für Aluminiumblätter, welcher ein phenolformaldehydharz, ein Epoxidnovolakharz und eine Phenoxyharz in Verbindung mit anderen bestimmten Bestandteilen enthalten kann. Auch dieser Patentschrift ist kein Hinweis auf die vorliegende Erfindung zu entnehmen, weil sie unter anderem nicht die erfindungsgemäß erforderlichen spezifischen relativen Mengen an Phenoxy- und Epoxidpolymeren verwendet. Weiterhin werden die bevorzugten, nichtflüssigen epoxidierten Novolalkpolymeren auch nicht angesprochen. Auch sei bemerkt, daß dieses Patent keine im Siebdruck verarbeitbare Überzugszusammensetzung betrifft und sich deshalb auch nicht mit den speziellen Problemen der vorliegenden Erfindung befaßt.

In der US-Patentschrift 3 424 707 werden Zusammensetzungen beschrieben, welche eine Mischung eines Phenoxyharzes kombiniert mit einem flüssigen Polyepoxid enthalten. Auch aus diesem Patent ist kein Hinweis auf die vorliegende Erfindung zu entnehmen, weil die erfindungsgemäßen speziellen epoxidierten Novolakpolymeren nicht angesprochen sind, und weil die Zusammensetzungen auch nicht als für Siebdruckanwendungen geeignet bezeichnet sind. Im Gegenteil, dieses Patent führt von der Verwendung der bevorzugten, nichtflüssigen epoxidierten Novolakpolymeren gemäß der Erfindung geradezu weg. In diesem Zusammenhang wird auf die Spalte 2, Zeilen 35 bis 43 der Patentschrift verwiesen.

Im Zusammenhang mit der vorliegenden Erfindung sind auch folgende US-Patentschriften von Interesse: USP 3 177 090, 3 316 323, 3 388 036, 3 445 282, 3 551 249, 3 554 958, 3 560 388 und 3 609 116, in denen Zusammensetzungen beschrieben sind, welche ein Phenoxypolymer oder ein Epoxidpolymer vom Bisphenol-A-Epichlorhydrintyp zusammen mit einem anderen Typ eines Epoxids enthalten können.

Im Zusammenhang mit der Beschreibung von Phenoxyharzen sind auch folgende US-Patentschriften von Bedeutung: USP 3 320 090, 3 336 257, 3 375 297, 3 395 118, 3 480 695, 3 509 095, 3 631 126, 3 881 977, 3 904 813 und 3 983 301.

Die Zusammensetzungen der vorliegenden Erfindung enthalten auch 13 bis 25 Gewichtsteile, vorzugsweise 16 bis 21 Gewichtsteile eines flüssigen Anhydrids einer Carbonsäure. Es kann ein Anhydrid einer Mono- oder vorzugsweise einer Polycarbonsäure eingesetzt werden. Das Anhydrid fungiert sowohl als Härtungsmittel für das Epoxidpolymere wie auch als Verdünnung, um die gewünschte Fließcharakteristik der Zusammensetzung leichter zu erhalten und zu gewährleisten.

Beispiele geeigneter Anhydride schließen Essigsäureanhydrid, Dodecenylbernsteinsäureanhydrid und vorzugsweise Methylbicyclo-2.2.1-hepten-2,3-dicarbonsäureanhydrid (nadic methyl anhydride Warenzeichen der Allied Chemical Corp.) ein. Die Anhydride müssen bei Normaltemperatur (um 25°C) flüssig sein.

Ein anderer wesentlicher Bestandteil der Zusammensetzung in der vorliegenden Erfindung ist kolloidales Siliciumdioxid, welches als Verdickungsmittel wirkt. Es ist wesentlich, daß das Verduckungsmittel kolloidales Siliciumdioxid ist. Es wurden beispielsweise andere allgemeine Typen von Verdikkungsmitteln zusammen mit den anderen Bestandteilen der vorliegenden Erfindung ausprobiert, diese haben jedoch keine befriedigende, im Siebdruck verarbeitbare Zusammensetzung mit den gewünschten Eigenschaften für die Verwendung als Lötmaske und permanenter Schutzüberzug für hochwertige gedruckte Schaltkarten ergeben. Es wurden beispielsweise Verdickungsmittel, die unter den Warenzeichen micromica 300, Britesorb erhältlich sind und andere Tone wie die unter dem Warenzeichen Bentone erhältlichen getestet, mit dem Ergebnis, daß diese für die Zwecke der vorliegenden Erfindung unbrauchbar sind.

Kolloidales Siliciumdioxid ist ein Siliciumdioxid mit einer Oberfläche von 50 bis 500 $m^2$/Gramm (bestimmt nach der Brunauer, Emmett und Teller-Stickstoffadsorptionsmethode, abgekürzt BET) und Teilchen mit einem Durchmesser von 5 bis 20 nm. Kolloidales Siliciumdioxid, das im Rahmen der vorliegenden Erfindung verwendet wird, ist beispielsweise ein Siliciumdioxid, das aus einem wasserlöslichen Silikat oder durch Hitzezersetzung von Äthylsilikat gewonnen wird. Das kolloidale Siliciumdioxid wird in der Literatur auch oft mit silica aerogel bezeichnet. Das Siliciumdioxid wird erhalten durch Hydrolyse oder Verbrennung von Siliciumtetrachlorid in einem Sauerstoff-Wasserstoffofen. Beispiele einiger kolloidaler Siliciumdioxidarten schließen die im Handel unter dem Warenzeichen Cab—O—Sil und Santocel erhältlichen Siliciumdioxide ein. Das Siliciumdioxid wird in Mengen von 4 bis 8, vorzugsweise von 4,5 bis 6 Gew.% eingesetzt.

Die Zusammensetzungen in der vorliegenden Erfindung enthalten auch ein flüchtiges Verdünnungsmittel in einer Menge, die eine Zusammensetzung mit einer Viskosität von 14 bis 50, vorzugsweise 20 bis 50 Pa·s ergibt. Die Viskosität wird bestimmt mit einem Haake Rotoviscogerät mit

einer Schubzahl von 249,6/sec. für 1,28 Minuten und 25°C. Im allgemeinen beträgt die Menge an Verdünnungsmittel 15 bis 25, vorzugsweise 19 bis 21 Gew.%.

Das Verdünnungsmittel wird so ausgewählt, daß es eine geeignete Flüchtigkeit aufweist und die Festbestandteile der Zusammensetzung zu lösen vermag. Die Flüchtigkeit sollte im Hinblick auf die geeignete Fließcharakteristik ausgewählt werden und sollte nicht zu hoch sein, damit die Blasenbildung in dem beschichteten Gegenstand auf ein Minimum reduziert wird. Beispiele geeigneter Lösungsmittel schließen Mono- und Dialkyläther von Äthylenglykol und auch bestimmte Derivate derselben ein, die im Handel unter den Warenzeichen.

Carbitol und Cellosolve erhältlich sind. Beispiele einiger spezifischer Verdünnungsmittel dieses Typs schließen Diäthylenglykol-mono-butyläther, erhältlich unter dem Warenzeichen Butylcarbitol, Diäthylenglykol-monobutylätheracetat, erhältlich unter dem Warenzeichen Butylcarbitolacetat, Diäthylenglykol-monoäthyläther-acetat, erhältlich unter dem Warenzeichen Carbitolacetat, Diäthylenglykol-monoäthyläther, erhältlich unter dem Warenzeichen Carbitol, Diäthylenglykol-dibutyläther, erhältlich unter dem Warenzeichen Dibutylcarbitol, Diäthylenglykol-diäthyläther, erhältlich unter dem Warenzeichen Diäthylcarbitol, Diäthylenglykolmonohexyläther, erhältlich unter dem Warenzeichen N-Hexylcarbitol, Diäthylenglykol-monomethyläther, erhältlich unter dem Warenzeichen Methylcarbitol, Diäthylenglykol-monomethylätheracetat, erhältlich unter dem Warenzeichen Methylcarbitolacetat, Äthylenglykol-monobutyläther, erhältlich unter dem Warenzeichen Butylcellosolve, Äthylenglykolmonobutylätheracetat, erhältlich unter dem Warenzeichen nung Butylcellosolveacetat, Äthylenglykolmonoäthylätheracetat, erhältlich unter dem Warenzeichen Cellosolveacetat, Äthylenglykolmonoäthyläther, erhältlich unter dem Warenzeichen Cellosolvesolvent, Äthylenglykoldibutyläther, erhältlich unter dem Warenzeichen Dibutylcellosolve, Äthylenglykolmonohexyläther, erhältlich unter dem Warenzeichen n-Hexylcellosolve, Äthylenglykolmonomethyläther, erhältlich unter dem Warenzeichen Methylcellosolve, Äthylenglykolmonomethylätheracetat, erhältlich unter dem Warenzeichen Methylcellosolveacetat und Äthylenglykolmonophenyläther, erhältlich unter dem Warenzeichen Phenylcellosolve ein.

Wenn es gewünscht wird, können auch Mischungen von Verdünnungsmitteln verwendet werden. Vorzugsweise wird als Verdünnungsmittel eine Mischung von Cellosolveacetat und Diäthylcarbitol verwendet. Wenn eine solche Mischung verwendet wird, enthält die Zusammensetzung im allgemeinen 15 bis 21 Gew.% Cellosolveacetat und 0,1 bis 3 Gew.% Diäthylcarbitol.

Das Cellosolveacetat wird hauptsächlich verwendet, um das Phenoxypolymer zu lösen, und das Diäthylcarbitol wird verwendet, um die gewünschte Verdampfungsgeschwindigkeit und die Viskosität einzustellen. Es wurde beispielsweise gefunden, daß der Ersatz von Diäthylcarbitol durch weniger bevorzugt Lösungsmittel wie Butylcarbitol zu einer weniger wirksamen Zusammensetzung führt, weil die Verdampfungscharakteristik des Diäthylcarbitols besser zu der Zusammensetzung der vorliegenden Erfindungs paßt.

Durch die geeignete Wahl aller zuvor genannten Bestandteile werden gemäß der vorliegenden Erfindung Zusammensetzungen erhalten, welche ausgezeichnete, im Siebdruck auftragbare Lötmasken ergeben und bei denen die bisher diskutierten Probleme bezüglich der Blasenbildung, einer kurzen Topfzeit, des Austretens der Zusammensetzungen unter dem Muster, des Klebens und des Erfordernisses einer genaueren Musterdefinition entfallen. Die Zusammensetzungen der vorliegenden Erfindung haben sehr lange Topfzeiten. In der Tat wurde die Topfzeit dieser Zusammensetzungen vor der Zugabe des Epoxidhärtungsmittels bis auf mindestens 1 Jahr verlängert, ohne daß Gelbildung oder ein Abbau der Zusammensetzungen bei etwa 4,4°C stattfand, Die Topfzeit betrug wenigstens 1 Monat bei normalen Raumtemperaturen von 25°C.

Wie zuvor diskutiert, wird durch die wohlüberlegte Auswahl einer Anzahl von Bestandteilen wie auch der Anpassung ihrer relativen Mengen eine Zusammensetzung erhalten, die im Siebdruck zu einer Lötmaske aufgetragen werden kann und eine gute Kombination der zuvor genannten gewünschten Eigenschaften besitzt.

Außer den den zuvor genannten Bestandteilen können die Zusammensetzungen gemäß der vorliegenden Erfindung, wenn es gewünscht wird, zusätzlich zu dem Anhydrid einen Beschleuniger für die Aushärtung des Epoxidpolymeren erhalten. Das beschleunigungsmittel wird in den bevorzugten Zusammensetzungen verwendet, weil es die Anwendung niedrigerer Temperaturen zür Härtung der Zusammensetzungen erleichtert. Das Beschleunigungsmittel wird im allgemeinen in Mengen bis zu etwa 6 Gew.% und vorzugsweise zwischen 2 und 6 Gew.% bzw. zwischen 3 und 4 Gew.% angewendet.

Vorzugsweise ist das Beschleunigungsmittel eine Flüssigkeit bei normalen Zimmertemperaturen und schließt bekannte Härtungsmittel für Epoxidpolymere vom Amid-, Imin- und Amintyp ein. Beispiele geeigneter Amide schließen Diäthylentriamin, 2,4,6-Tris-N,N'-dimethylaminoäthylphenol, Triäthylentetramin und Tetraäthylenpentamin ein. Die geeigneten Amine sind im allgemeinen Polyamine und enthalten wenigstens zwei primäre oder sekundäre Stickstoffatome und insgesamt wenigstens 3 aktive Wasserstoffatome. Beispiele geeigneter, im Handel erhältlicher, Epoxidhärtungsmittel werden in der Veröffentlichung der Shell Chemical Company mit dem Titel "Product Guide", Epon[R] resins SC:71-85, 1971 abgehandelt. Das im Rahmen der vorliegenden Erfindung bevorzugte Härtungsmittel ist das 2-Äthoxycapronsäuresalz des 2,4,6-Tris-N,N'-dimethylaminomethylphenols, welches von der Schell Oil Company unter dem Warenzeichen Epon-D im Handel erhältlich ist. Das Epon-D ist das

bevorzugte Härtungsmittel, weil es die Verarbeitbarkeit der Überzugszusammensetzung im Siebdruck nicht nachteilig beeinflußt und gerade die richtige Beschleunigung der Aushärtung bewirkt, indem es, im Vergleich mit anderen im Handel erhältlichen Härtungsmitteln nicht zu schnell reagiert. Das Härtungsmittel zur Aushärtung des Epoxidharzes wird zu der Zusammensetzung im allgemeinen unmittelbar vor dem Auftragen derselben zugegeben.

Zusätzlich zu den zuvor beschriebenen Bestandteilen können die Zusammensetzungen der vorliegenden Erfindung wahlweise auch bis zu 1 und vorzugsweise bis zu etwa 0,5 Gew.% eines Verlaufmittels enthalten, um den Erhalt glatter Überzüge zu erleichtern. Beispiele solcher Verlaufmittel schließen Modaflow (Warenzeichen der Monsanto Company), Aluminiumstearat, Calciumstearat, Sucrosebenzoat, hochmolekulare, nichtionische oberflächenaktive Mittel und ein Material, welches als Farbadditiv Nr. 3 bekannt ist und eine 12%ige Lösung eines alkylsubstituierten cyclischen Silsexquioxans in Toluol darstellt, ein.

Zusätzlich können die Zusammensetzungen auch in Mengen bis zu etwa 0,2, vorzugsweise bis zu etwa 0,1 Gew.% einen optischen Aufhellers enthalten, welcher zur Bestimmung dient, ob die Zusammensetzung alle gewünschten vorher bestimmten Bereiche bedeckt hat, wenn man Ultraviolettlicht auf die Zusammensetzung einstrahlt und den Anteil des reflektierten Lichts beobachtet. Ein Beispiel eines solchen optischen Aufhellers ist im Handel erhältlich unter dem Warenzeichen Tin-O-Pal PCP.

Wenn es gewünscht wird, können die Zusammensetzungen entsprechend ihrem Verwendungszweck aus kleine Mengen von Füllstoffen oder Pigmenten (bis zu etwa 5 Gew.%) wie Titandioxid oder Calciumcarbonat enthalten.

Die Zusammensetzungen der vorliegenden Erfindung finden bevorzugte Anwendung im Siebdruck zur Herstellung von Überzügen, welche als Lötmasken dienen und auf der Schaltkarte als Schutzüberzug für den Schaltkreis zurückbleiben. In den meisten Fällen werden die Überzüge in Schichtdicken von 0,0025 mm bis 0,25 mm, vorzugsweise von 0,01 mm bis 0,10 mm aufgetragen.

Die Zusammensetzungen der vorliegenden Erfindung können durch Anwendung erhöhter Temperaturen gehärtet werden. Typische Temperaturen von 100 bis 160°C bei einer Einwirkungsdauer von 20 bis 40 Minuten sind für Aushärtung von Zusammensetzungen, in denen Epon-D als Beschleuniger verwendet wird, geeignet. Wenn as gewünscht wird, kann die Wahl verschiedener Temperaturen und/oder Zeiten bei Anwendung anderer Bescheuniger ohne aufwendige Experimente durch einen Fachmann bei Kenntnis der vorliegenden Erfindung durchgeführt werden. Es sei bemerkt, daß die Temperatur und Zeit zur Ausführung der härtung zueinander invers sind. Beispielsweise kann die Zeit zur Härtung, wenn die Temperatur erhöht wird, erniedrigt werden. Wenn die Zusammensetzung zur Herstellung einer Lötmaske verwendet wird, wird nach der Aushärtung der zuvor beschriebenen Zusammensetzung eine Lötlegierung auf die Unterlage aufgetragen. Dabei wird eine in einem Bildmuster mit einer Lötlegierung bedeckte Unterlage erhalten, wobei die mit Lötlegierung bedeckten Bereiche den nicht mit der Zusammensetzung bedeckten Bereichen entsprechen.

Die nachfolgenden Ausführungsbeispiele dienen zur Erläuterung der Erfindung.

## Beispiel 1

Etwa 1230,6 Gewichtsteile (etwa 29,3%) einer 29,5%igen Lösung eines phenoxyharzes in Cellosolveacatat, welche unter dem Warenzeichen PKHC erhältlich ist, werden in einen Hochgeschwindigkeitsplanetenmischer gegeben. Das Phenoxyharz hat ein molekulargewicht von etwa 29 500 bis 32 500 und ist vom Epichlorhydrin-Bisphenol-A-Typ. Etwa 784,1 Gewichsteile (etwa 18,67%) Nadicmethylanhydrid werden zu der Phenoxyharzlösung gegeben, gefolgt von etwa 4,2 Gewichtsteilen (etwa 0,1%) des Farbzusatzes Nr. 3 und etwa 4,2 Gewichtsteilen (etwa 0,1%) von Diäthylcarbitol. Anschließend werden etwa 1948,4 Gewichtsteile (etwa 46, 39%) eines epoxidierten Novolaks, der unter dem Warenzeichen DEN 439 erhältlich ist, zugesetzt. Der epoxidierte Novolak wird vor seiner Zugabe auf etwa 76,7°C erhitzt, damit er fließt. Danach werden 2,9 Gewichtsteile (etwa 0,07%) Tin-O-Pal und etwa 225.5 Gewichtsteile (etwa 5,37%) von Cab-O-Sil M—5 zu der Mischung zugegeben. Die Zugabe der Bestandteile nimmt etwa 10 Minuten in Anspruch.

Nach der Zugabe aller Bestandteile wird der Mischer geschlossen und die Zusammensetzung wird unter Anwendung eines Hochgeschwindigkeitsrührers gemischt. Das Rühren wird solange fortgesetzt, bis das Cab-O-Sil vollständig in die Mischung eingerührt ist, was im allgemeinen etwa 15 bis 25 Minuten in Anspruch nimmt. Etwa 153,7 Gewichtsteile (etwa 3,66%) von Epon-D werden zu der Zusammensetzung zugegeben.

Die zuvor angegebene Zusammensetzung wird in einem vorherbestimmten Muster unter Anwendung einer Siebdrucktechnik und eines Siebs mit einer lichten Maschenweite von 0,125 mm (120 mesh) in einer Schichtdicke von etwa 0,05 mm auf eine Seite einer gedruckten Schaltkarte aufgetragen. Die beschichtete Schaltkarte wird durch Anwendung einer erhöhten Temperatur von etwa 80°C in 10 Minuten teilgehärtet. Auf die andere Seite der gedruckten Schaltkarte wird in einem vorherbestimmten Muster die zuvor angegebene Zusammensetzung unter Anwendung der Siebdrucktechnik und eines Siebs mit einer lichten Maschenweite von 0,125 mm (120 mesh) in einer Schichtdicke von etwa 0,05 mm aufgetragen. Beide Seiten der beschichteten Karte werden dann etwa 40 Minuten lang bei einer Temperatur von etwa 150°C gehärtet.

Der Überzug ist sehr gleichmäßig, er zeigt ganz wenig Blasenbildung und besitzt gute Widerstandsfähigkeiten gegen das Lötmittel. Nach einem 400 Stunden dauernden Test bei hohen Temperaturen (etwa 75—100°C) in einer hohen Feuchtigkeit (etwa 80% relative Luftfeuchtigkeit) beträgt die isolierende Charakteristik des Überzugs wenigstens etwa $10^8$ Ohm. Außerdem folgt der Überzug dem Muster ganz genau. DEN 439 ist ein Epoxidnovolakharz, welches durch Formel 3 (Patentanspruch 3) charakterisiert ist, in der n = 1,8 ist.

Beispiel 2

Das Verfahren nach Beispiel 1 wird wiederholt mit der Ausnahme, das die Zusammensetzung etwa 29,3% einer 29,5%igen Lösung des Phenoxyharzes PKHC in Cellosolveacetat, etwa 18,1% Nadicmethylanhydrid, etwa 0,98% Farbzusatz Nr. 3, etwa 1.41% Diäthylcarbitol, etwa 46% DEN 439, etwa 0,07% Tin-O-Pal, etwa 4,3% Cab-O-Sil M—5 und etwa 3,66% Epon-D enthält. Die erhaltenen Ergebnisse sind denen von Beispiel 1 ähnlich.

Beispiel 3

Das allgemeine Verfahren von Beispiel 1 wird wiederholt mit der Ausnahme, daß die Zusammensetzung etwa 28,9% einer 29,5%igen Lösung des Phenoxyharzes PKHC in Cellosolveacetat, etwa 17.34% Nadicmethylanhydrid, etwa 1,13% Farbzusatz Nr. 3, etwa 1,92% Diäthylcarbitol, etwa 45,8% DEN 439, etwa 0.07% Tin-O-Pal, etwa 4,8% Cab-O-Sil M—5 und etwa 3,66% Epon-D enthält. Die erhaltenen Ergebnisse sind denen von Beispiel 1 ähnlich.

Beispiel 4

Das allgemeine Verfahren von Beispiel 1 wird wiederholt mit der Ausnahme, daß die setzung etwa 29,3% einer 29,5%igen Lösung des Phenoxyharzes PKHC in Cellosolveacetat, etwa 18,34% Nadicmethylanhydrid, etwa 1,12% Farbzusatz Nr. 3, etwa 2,13% Diäthylcarbitol, etwa 44,3% DEN 439, etwa 0,07% Tin-O-Pal, etwa 4,8% Cab-O-Sil M—5 und etwa 3,66% Epon-D enthält. Die erhaltenen Ergebnisse sind denen von Beispiel 1 ähnlich.

Beispiel 5

Das allegmeine Verfahren von Beispiel 1 wird wiederholt mit der Ausnahme, daß die Zusammensetzung etwa 28,8% einer 29,5%igen Lösung des Phenoxyharzes PKHC in Cellosolveacetat, etwa 18,22% Nadicmethylanhydrid, etwa 1,1% Farbzusatz Nr. 3, etwa 1,89% Diäthylcarbitol, etwa 45,14% DEN 439, etwa 0,07% Tin-O-Pal, etwa 4,7% Cab-O-Sil M—5 und etwa 3,66% Epon-D enthält. Die erhaltenen Ergebnisse sind denen von Beispiel 1 ähnlich.

Beispiel 6

Das allgemeine Verfahren von Beispiel 1 wird wiederholt mit der Ausnahme, daß die Zusammensetzung etwa 29,1% einer 29,5%igen Lösung des Phenoxyharzes PKHC in Cellosolveacetat, etwa 18,2% Nadicmethylanhydrid, etwa 1,05% Farbzusatz Nr. 3, etwa 1,84% Diäthylcarbitol, etwa 45% DEN 439, etwa 0,07% Tin-O-Pal, etwa 4,74% Cab-O-Sil M—5 und etwa 3,66% Epon-D enthält. Die erhaltenen Ergebnisse sind denen von Beispiel 1 ähnlich.

Beispiel 7

Das allgemeine Verfahren von Beispiel 1 wird wiederholt mit der Ausnahme, daß die Zusammensetzung etwa 22% einer 29,5%igen Lösung des Phenoxyharzes PKHC in Cellosolveacetat, etwa 18,9% Nadicmethylanhydrid, etwa 1% Farbzusatz Nr. 3, etwa 1,47% Diäthylcarbitol, etwa 48,1% DEN 438, etwa 0,19% Tin-O-Pal, etwa 4,93% Cab-O-Sil M—5 und etwa 3,66% Epon-D enthält. DEN 438 ist ein Epoxidnovolakharz mit der Formel des bevorzugten Epoxidnovolakharzes, in der n = 1,6 ist, verglichen mit 1,8 für DEN 439. Die erhaltenen Ergebnisse sind denen von Beispiel 1 ähnlich, mit der Ausnahme, daß ein gewisses Ausbluten während des Härtens beobachtet wird. Die Zusammensetzung zeigt gute Eigenschaften im Hinblick auf das Siebdruckverfahren.

Beispiel 8

Das allgemeine Verfahren von Beispiel 1 wird wiederholt mit der Ausnahme, daß die Zusammensetzung etwa 25,3% einer 29,5%igen Lösung des Phenoxyharzes PKHC in Cellosolveacetat, etwa 18,1% Nadicmethylanhydrid, etwa 0,98% Farbzusatz Nr. 3, etwa 1,41% Diäthylcarbitol, etwa 46% DEN 438, etwa 0,18% Tin-O-Pal, etwa 4,72% Cab-O-Sil M—5 und etwa 3,66% Epon-D enthält. Die erhaltenen Ergebnisse sind denen von Beispiel 7 ähnlich.

Beispiel 9

Das allgemeine Verfahren von Beispiel 1 wird wiederholt mit der Ausnahme, daß die Zusammensetzung etwa 26,5% einer 29,5%igen Lösung des Phenoxyharzes PKHC in Cellosolveacetat, etwa 1,75% Nadicmethylanhydrid, etwa 0,96% Farbzusatz Nr. 3, etwa 1,39% Diäthylcarbitol, etwa 45,2% DEN 438, etwa 0,18% Tin-O-Pal, etwa 4,64% Cab-O-Sil M—5 und etwa 3,66% Epon-D enthält. Die erhaltenen Ergebnisse sind denen von Beispiel 7 ähnlich.

Beispiel 10

Das allgemeine Verfahren von Beispiel 1 wird wiederholt mit der Ausnahme, daß die Zusammensetzung etwa 28,3% einer 29,5%igen Lösung des Phenoxyharzes PKHC in Cellosolveacetat, etwa 17,33% Nadicmethylanhydrid, etwa 0,94% Farbzusatz Nr. 3, etwa 1,35% Diäthylcarbitol, etwa 44% DEN 438, etwa 0,18% Tin-O-Pal, etwa 4,52% Cab-O-Sil M—5 und etwa 3,66% Epon-D enthält. Die erhaltenen Ergebnisse sind nicht so gut, wie diejenigen von Beispiel 7, weil die Zusammensetzung sich nicht so leicht im Siebdruck auftragen läßt wie diejenige von Beispiel 7. Die Verarbeitbarkeit im Siebdruck der Zusammensetzung dieses Beispiels, die zwar für bestimmt Anwendungen ausreichend ist, ist nicht ausreichend für die Beschichtung von hochwertigen gedruckten Schaltkreisen, die in den Handel kommen sollen.

**Patentansprüche**

1. In Siebdruck verarbeitbare, härtbare Zusammensetzung, gekennzeichnet durch folgende Bestandteile:

A) 31 bis 55 Gew.% eines epoxidierten Novolaks der allgemeinen Formel:

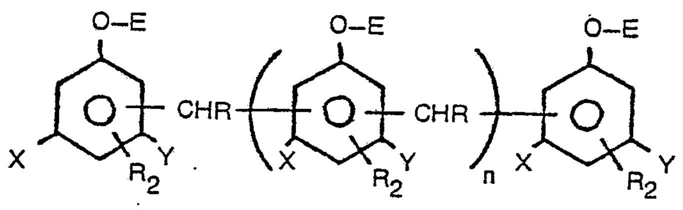

(1)

in der n wenigstens 0,2 ist; R Wasserstoff, Alkyl, Alkylen, Aryl, Aralkyl, Alkaryl, Cycloalkyl oder Furyl bedeutet; X und Y Wasserstoff, Chlor, Alkyl oder Hydroxyl bedeuten; $R_2$ Wasserstoff, Chlor oder Kohlenwasserstoffgruppe wie Alkyl, Aryl, Aralkyl, Alkaryl und Cycloalkyl bedeutet; E Wasserstoff oder Epoxidalkylgruppe bedeutet und wenigstens zwei Reste E pro Molekül Epoxidalkylgruppen sind, wobei die Epoxidalkylgruppe dargestellt wird durch die allgemeine Formel

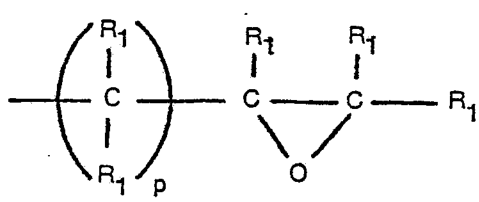

in der p ein Zahl von 1 bis 8 ist und $R_1$ Wasserstoff oder eine Alkylgruppe mit bis zu 7 Kohlenstoffatomen bedeutet und die Anzahl der Kohlenstoffatome in jeder Epoxidalkylgruppe 10 nicht übersteigt;

B) 6 bis 12 Gew.% eines thermoplastischen Polyhydroxyäther-Reaktionsproduktes eines mehrkernigen zweiwertigen Phenols und Epichlorhydrin, das keine 1,2 Epoxidgruppen enthält, der allgemeinen Formel

$$-\!\!\left[O-A-O-CH_2-\underset{\substack{|\\OH}}{CH}-CH_2\right]_m\!\!- \qquad (2)$$

in der m wenigstens 30 ist und A der Rest eines mehrkernigen zweiwertigen Phenols;

C) 15 bis 21 Gew.% eines flüssigen Anhydrids einer Carbonsäure;

D) 4 bis 8 Gew.% kolloidalen Siliciumdioxids und

E) flüssiges Verdünnungsmittel in einer Menge, daß die Zusammensetzung eine Viskosität von 14 bis 50 Pa · s bestimmt mit dem Haake Rotovisco-Viskosimeter mit einer Schubzahl von 249,6/sec für 1,28 Minuten und 25°C, aufweist

und ein Verhältnis von (A) zu (B) zwischen 7:1 und 4:1.

2. Zusammensetzung nach Anspruch 1, dadurch gekennzeichnet, daß der epoxidierte Novolak (Bestandteil A) nichtflüssig ist.

3. Zusammensetzung nach Anspruch 1, dadurch gekennzeichnet, daß der epoxidierte Novolak (Bestandteil A) dargestellt wird durch die allgemeine Formel:

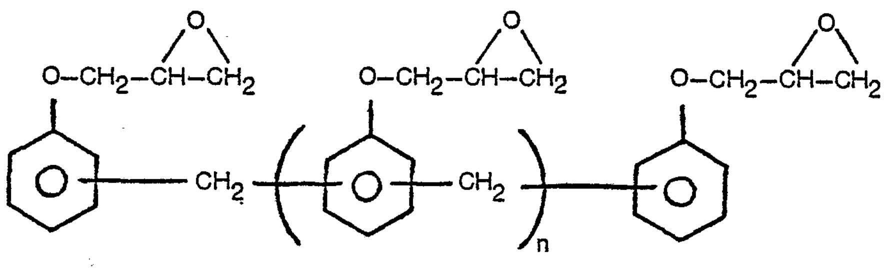

(3)

in der n 1,5 bis 2 ist.

4. Zusammensetzung nach Anspruch 1, dadurch gekennzeichnet, daß der thermoplastische Polyhydroxyäther (Bestandteil B) ein Reaktionsprodukt aus Bisphenol-A und Epichlorhydrin ist und dargestellt wird durch die allgemeine Formel:

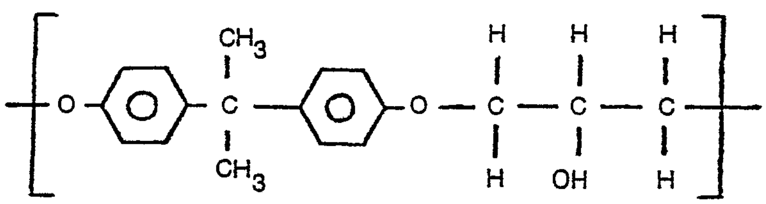

(4)

und das Molekurlargewicht dieses Polyhydroxyäthers zwischen 20 000 und 50 000, vorzugsweise zwischen 25 000 und 38 000 liegt.

5. Zusammensetzung nach Anspruch 1, dadurch gekennzeichnet, daß das Anhydrid (Bestandteil C) Methylbicyclo-2.2.1-hepten-2,3-dicarbonsäureanhydrid (Nadicmethylanhydrid) ist.

6. Zusammensetzung nach Anspruch 1, dadurch gekennzeichnet, daß das kolloidale Siliciumdioxid (Bestandteil D) eine Oberfläche von 50 bis 400 $m^2$/Gramm aufweist und die Teilchen einen Durchmesser von 5 bis 20 nm besitzen.

7. Zusammensetzung nach Anspruch 1, dadurch gekennzeichnet, daß sie außerdem 2 bis 6 Gew.% Beschleunigungsmittel für die Härtung des Epoxidharzes (Bestandteil F) enthält.

8. Zusammensetzung nach Anspruch 7, dadurch gekennzeichnet, daß das Beschleunigungsmittel das 2-Äthoxycapronsäuresalz des 2,4,6-Tris-N,N'-dimethylaminomethylphenols ist.

9. Zusammensetzung nach Anspruch 1, dadurch gekennzeichnet, daß das flüchtige Verdünnungsmittel (Bestandteil E) ein Mono- oder Dialkyläther des Äthylenglykols oder eines Derivats desselben ist.

10. Zusammensetzung nach Anspruch 1, dadurch gekennzeichnet, daß das flüchtige Verdünnungsmittel eine Mischung aus 15 bis 21 Gew.% Äthylenglykol-monoäthylätheracetat (Cellosolveacetat) und 0,1 bis 3 Gew.% Diäthylenglykol-diäthyläther (Diäthylcarbitol) ist.

11. Zusammensetzung nach den Ansprüchen 1 und 7, gekennzeichnet durch 45 bis 50 Gew.% an Bestandteil (A), 7,5 bis 9,5 Gew.% an Bestanteil (B), 16 bis 21 Gew.% an Bestandteil (C), 4,5 bis 6 Gew.% an Bestandteil (D), 15 bis 25 Gew.%, vorzugsweise 19 bis 21 Gew.% an Bestandteil (E) und 2 bis 6 Gew.%, vorzugsweise 3 bis 4 Gew.% an Bestandteil (F) zur Härtung des Epoxidharzes, wobei die angegebenen Mengen auf den Gesamtgehalt von (A), (B), (C), (D), (E) und (F) in der Zusammensetzung bezogen sind.

12. Zusammensetzung nach Anspruch 1, dadurch gekennzeichnet, daß sie außerdem ein Verlaufmittel in einer Menge bis zu 1 Gew.% enthält.

13. Zusammensetzung nach Anspruch 1, dadurch gekennzeichnet, daß das Verhältnis von (A) zu (B) 4,5:1 bis 7:1, vorzugsweise etwa 5,5:1 ist.

14. Zusammensetzung nach Anspruch 1, dadurch gekennzeichnet, daß sie außerdem einen optischen Aufheller in einer Menge bis zu 0,2 Gew.% enthält.

15. Zusammensetzung nach Anspruch 1, dadurch gekennzeichnet, daß sie außerdem Füllstoffe oder Pigmente in einer Menge bis zu 5 Gew.% enthält.

16. Gehärteter Überzug auf einer Unterlage, gekennzeichnet durch eine Zusammensetzung nach einem oder mehreren der Ansprüche 1 bis 15.

17. Verfahren zum Löten von Schaltkarten, dadurch gekennzeichnet, daß eine Zusammensetzung nach den Ansprüchen 1 bis 15 in einem gewünschten Muster im Siebdruck auf eine Unterlage aufgetragen und bei Temperaturen zwischen 100 und 150°C gehärtet wird, und daß anschließend eine Lötlegierung in den freiliegenden Bereichen des Musters auf die Unterlage aufgetragen wird.

**Claims**

1. A screen-printing curable composition characterized by the following constituents:

A) 31 to 55% by weight of an epoxidized novolac represented by the general formula:

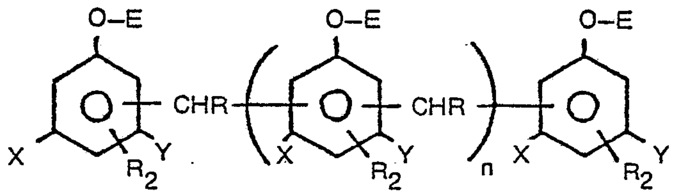

(1)

wherein n is at least 0.2; R is hydrogen, alkyl, alkylene, aryl, aralkyl, alkaryl, cycloalkyl or furyl; X and Y are hydrogen, chlorine or a hydrocarbon group, such as alkyl, aryl, aralkyl, alkaryl and cycloalkyl; E is hydrogen or an epoxyalkyl group, at least two E groups per molecule being an epoxyalkyl group, and wherein the epoxyalkyl group is represented by the general formula:

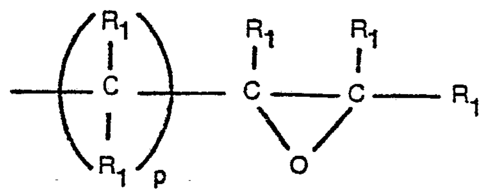

wherein p is an integer from 1 to 8 and $R_1$ is hydrogen or an alkyl group of up to 7 carbon atoms, and wherein the number of carbon atoms in any epoxyalkyl group totals no more than 10 carbon atoms;

B) 6 to 12% by weight of a thermoplastic polyhydroxy ether reaction product of a polynuclear dihydric phenol and epichlorohydrin substantially free of 1,2-epoxy groups having the general formula:

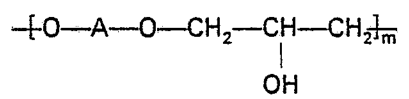

(2)

wherein m is at least 30 and A is the residuum of a polynuclear dihydric phenol;

C) 15 to 21% by weight of a liquid anhydride of carboxylic acid;

D) 4 to 8% by weight of colloidal silica; and

E) volatile diluent in an amount sufficient to provide a composition with a viscosity of 14 to 50 Pa·s determined with a Haake Rotovisco with a shear rate of 249.6/sec. for 1.28 minutes at 25°C; and wherein the ratio of (A) to (B) is from 7:1 to 4:1.

2. The composition according to claim 1, characterized in that the epoxidized novolac (constituent A) is a nonliquid.

3. The composition according to claim 1, characterized in that the epoxidized novolac (constituent A) is represented by the general formula:

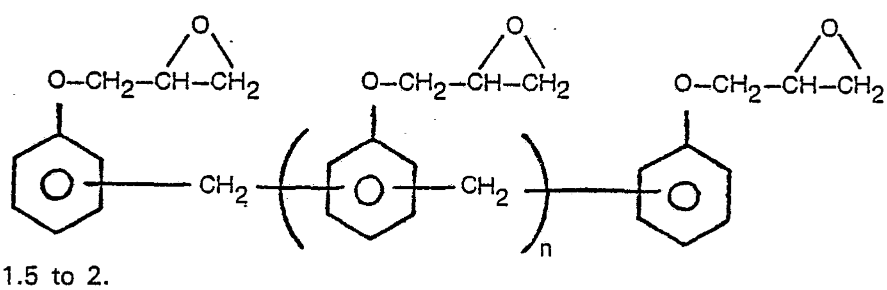

(3)

wherein n is 1.5 to 2.

4. The composition according to claim 1, characterized in that the thermoplastic polyhydroxy ether (constituent B) is the reaction product of bisphenol-A and epichlorohydrin and is represented by the general formula:

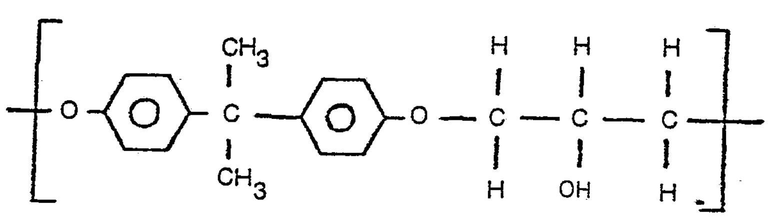

(4)

and the molecular weight of this polyhydroxy either is from 20 000 to 50 000, preferably from 25 000 to 38 000.

5. The composition according to claim 1, characterized in that the anhydride (constituent C) is methyl bicyclo-2.2.1-heptene-2,3-dicarboxylic anhydride (nadic methyl anhydride).

6. The composition according to claim 1, characterized in that colloidal silica (constituent D) has a surface area of 50 to 400 $m^2$/gram and the particles have a diameter of 5 to 20 nm.

7. The composition according to claim 1, characterized in that it further includes 2 to 6% by weight of an accelerating agent for the cure of the epoxy (constituent F).

8. The composition according to claim 7, characterized in that the accelerating agent is 2-ethoxyhexanoic acid salt of 2,4,6-tris-N,N'-dimethylaminomethyl phenol.

9. The composition according to claim 1, characterized in that the volatile diluent (constituent E) is a mono- or dialkyl ether of ethylene glycol or derivative thereof.

10. The composition according to claim 1, characterized in that the volatile diluent is a mixture of 15 to 21% by weight of ethylene glycol monoethyl ether acetate (cellosolve acetate) and 0.1 to 3% by weight of diethylene glycol diethyl ether (diethyl carbitol).

11. The composition according to claims 1 and 7, characterized by 45 to 50% by weight of constituent (A), 7.5 to 9.5% by weight of constituent (B), 16 to 21% by weight of constituent (C), 4.5 to 6% by weight of constituent (D), 15 to 25% by weight, preferably 19 to 21% by weight, of constituent (E), and 2 to 6% by weight, preferably 3 to 4% by weight, of constituent (F) for cure of the epoxy, wherein said amounts are based upon the total amount of (A), (B), (C), (D), (E), and (F) in said composition.

12. The composition according to claim 1, characterized in that it further includes a leveling agent in an amount of up to 1% by weight.

13. The composition according to claim 1, characterized in that the ratio of (A) to (B) is 4.5:1 to 7:1, preferably about 5.5:1.

14. The composition according to claim 1, characterized in that it further includes a UV brightener in an amount of up to 0.2% by weight.

15. The composition according to claim 1, characterized in that it further includes fillers or pigments in an amount of up to 5% by weight.

16. A cured coating on a substrate characterized by a composition according to any one or combination of claims 1 to 15.

17. A method of soldering circuit boards, characterized in that a composition according to claims 1 to 15 is screen-printed in a desired pattern onto a substrate and cure at temperatures from 100 to 150°C, and that subsequently a solder alloy is applied in the areas of exposed pattern not coated with said composition.

**Revendications**

1. Composition durcissable utilisable dans l'impression par écran, caractérisée en ce qu'elle comprend les composants suivants:

A) de 31 à 55% en poids d'un novolak époxidé de la formule générale:

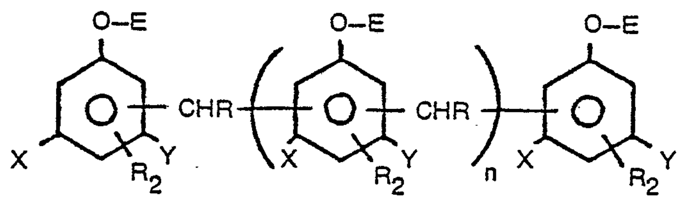

(1)

où n est au moins égale à 0,2; R est constitué par de l'hydrogène, de l'alkyle, de l'alkylène, de l'aryle, de l'aralkyle, de l'alkaryle, du cycloalkyle ou du furyle; X et Y sont constitués par de l'hydrogène, du chlore, de l'alkyle ou du hydroxyle; $R_2$ est constitué par de l'hydrogène, du chlore ou des groupes d'hydrocarbures comme l'alkyle, l'aryle, l'aralkyle, l'alkaryle et le cycloalkyle; E est constitué de l'hydrogène ou un groupe d'époxyalkyle, au moins deux éléments E par molécule étant des groupes d'époxyalkyle, le groupe d'époxyalkyle étant représenté par la formule générale:

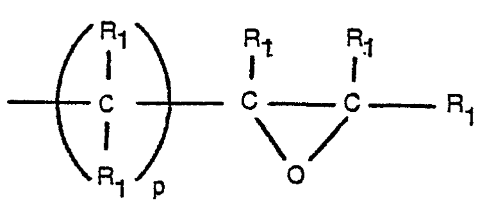

où p est un nombre entier de 1 à 8, et $R_1$ est de l'hydrogène ou un groupe d'alkyles comportant jusqu'à 7 atomes de carbone, et où le nombre d'atomes de carbone dans chaque groupe d'époxyalkyle ne dépasse pas 10;

B) de 6 à12% en poids d'un produit de réaction de polyhydroxy-éther thermoplastique d'un phénol dihydrique polynucléaire et d'un épichlorohydrine ne comportant pas de groupe de 1, 2-époxy, de la formule générale:

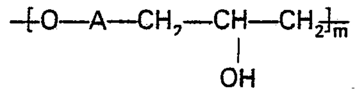

(2)

où m est au moins égale 30 et A est le reste d'un phénol dihydrique polynucléaire;

C) de 15 à 21% en poids d'un anhydride liquide d'un acid carboxylique;

D) de 4 à 8% en poids de dioxyde de silicium colloïdal; et

E) un diluant volatil, en quantité suffisante pour obtenir une composition ayant une viscosité de 14 à 50 Pa s déterminée à l'aide d'un Rotoviscosimètre Haake à une vitesse de 249,6/sec pour 1,28 minutes à 25°C; et

dans lequel le rapport de A) à B) est compris entre 7:1 et 4:1.

2. Composition selon la revendication 1, caractérisée en ce que le novolak époxydé (composant A) n'est pas liquide.

3. Composition selon la revendication 1, caractérisée en ce que le novolak époxydé (composant A) est représenté par la formule générale:

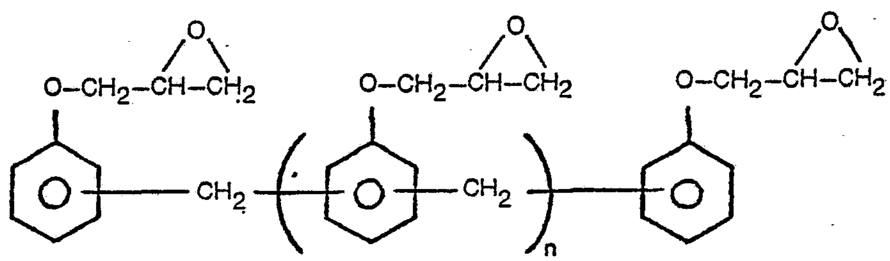

(3)

où n est compris entre 1,5 et 2.

4. Composition selon la revendication 1, caractérisé en ce que polyhydroxy-éther thermoplastique (composant B) est un produit de réaction composé de bisphénol-A et d'épichlorohydrine, qui est représenté par la formule générale:

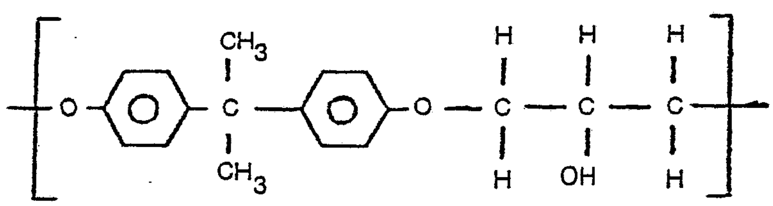

(4)

et en ce que le poids moléculaire de ce polyhydroxyéther est compris entre 20 000 et 50 000, de préférence entre 25 000 et 38 000.

5. Composition selon la revendication 1, caractérisé en ce que l'anhydride (composant C) est l'anhydride méthyl bicyclo-2.2.1-heptène-2,3-dicarboxylique (anhydride-nadique méthyl).

6. Composition selon le revendication 1, caractérisée en ce que le dioxyde de silicium colloïdal (composant D) a une surface comprise entre 50 et 400m²/g et les particules ont un diamètre compris entre 5 et 20 nm.

7. Composition selon la revendication 1, caractérisée en ce qu'elle contient en outre de 2 à 6% en poids d'un agent d'accélération pour le durcissement de la résine époxy (composant F).

8. Composition selon la revendication 7, caractérisée en ce que l'agent d'accélération est un sel de l'acide 2-éthoxyhexanoïque du 2,4,6-tris-N,N'-diméthylaminométhyl phénol.

9. Composition selon la revendication 1, caractérisée en ce que le diluant volatil (composant E) est un mono ou dialkyle éther de l'éthylène glycol ou d'un dérivé de celui-ci.

10. Composition selon la revendication 1, caractérisée en ce que le diluant volatil est un mélange de 15 à 21% en poids d'éthylène glycol monoéthyle éther acétate (cellosolve acétate) et de 0,1 à 3% en poids de diéthylène glycol diéthyle éther (diéthyle carbitol).

11. Composition selon les revendication 1 et 7, caractérisée par 45 à 50% en poids du composant (A), 7,5 à 9,5% en poids du composant (B), 16 à 21% en poids du composant (C), 4,5 à 6% en poids du composant (D), 15 à 25% en poids, de préférence 19 à 21% en poids, du composant (E), et 2 à 6% en

poids, de préférence 3 à 4% en poids, du composant (F) pour durcir la résine époxy, les quantités données se rapportant au contenu total de (A), (B), (C), (D), (E) et (F) dans la composition.

12. Composition selon la revendication 1, caractérisée en ce qu'elle contient en outre un agent d'étalement dans une quantité pouvant atteindre 1% en poids.

13. Composition selon la revendication 1, caractérisée en ce que le rapport de (A) à (B) est de 4,5:1 à 7:1 de préférence environ 5,5:1.

14. Composition selon la revendication 1, caractérisée en ce qu'elle contient en outre un brillanteur UV dans une quantité pouvant atteindre 0,2% en poids.

15. Composition selon la revendication 1, caractérisée en ce qu'elle contient en outre des agents de remplissage ou des pigments dans une quantité pouvant atteindre 5% en poids.

16. Revêtement durci sur un support, caractérisé par ce quil est constitué d'une composition selon l'une ou plusieurs des revendications 1 à 15.

17. Procédé pour souder des panneaux de circuits, caractérisé en ce qu'une composition selon les revendications 1 à 15 est déposée selon une configuration désirée par la technique d'impression par écran sur un support et cuite à des températures comprises entre 100 et 150°C, et en ce qu'ensuite un alliage de soudure est déposé sur le support dans les régions exposées de la configuration.